**Europäisches Patentamt**

**European Patent Office**

**Office européen des brevets**

(11) Numéro de publication: **0 191 270**
**B1**

(12) **FASCICULE DE BREVET EUROPÉEN**

(45) Date de publication du fascicule du brevet:
23.11.88

(21) Numéro de dépôt: **85810588.5**

(22) Date de dépôt: **12.12.85**

(51) Int. Cl.⁴: **H 05 K 7/10, H 01 R 13/24**

(54) **Socle pour composant électronique.**

(30) Priorité: **01.02.85 CH 475/85**
**26.02.85 CH 879/85**

(43) Date de publication de la demande:
**20.08.86 Bulletin 86/34**

(45) Mention de la délivrance du brevet:
**23.11.88 Bulletin 88/47**

(84) Etats contractants désignés:
**AT BE CH DE FR GB IT LI LU NL SE**

(56) Documents cité:
**DE-A-2 431 816**
**FR-A-2 434 484**
**US-A-3 409 861**
**US-A-3 808 582**
**US-A-4 252 390**

**MACHINE DESIGN, vol. 47, no. 3, 6 février 1975,
page 41; "Vibrationproof connector clamps ICs to
PCB"**

(73) Titulaire: **CFG S.A., 2 avenue de Lonay, CH- 1110
Morges (CH)**

(72) Inventeur: **Cohen, Salomon, Avenue de Longeraie
5, CH- 1006 Lausanne (CH)**
Inventeur: **Cohen, Marc, Avenue Florimont 11, CH-
1006 Lausanne (CH)**

(74) Mandataire: **Vuille, Roman, c/o KIRKER & Cie
S.A. 14, rue du Mont- Blanc Case Postale 872,
CH- 1211 Genève 1 (CH)**

LIBER, STOCKHOLM 1988

## Description

L'invention se rapporte à un socle de maintien et de raccordement pour un composant électronique selon le préambule des revendications 1 et 11. Un tel socle est connu par exemple du DE-A-2 431 816.

Les composants électroniques sont souvent devenus plus complexes et présentent plus de points de raccordement avec le circuit dans le cadre duquel ils sont appelés à fonctionner. Comme par ailleurs il arrive qu'un tel composant devienne défectueux et qu'on veuille le remplacer sans remplacer tout le circuit qui l'entoure, il devient nécessaire d'utiliser un socle pour une fixation et un raccordement amovibles du composant. Comme une force de contact minimum entre deux pièces galvaniques est nécessaire pour garantir un bon contact durant un temps appréciable et que, d'autre part, les composants deviennent de plus en plus petits, l'insertion simultanée de nombreuses tiges de contact dans les douilles élastiques d'un socle devient problématique et des constructions permettant l'insertion sans force (dites ZIF = zero insertion force) ont été développées pour les composants dont les tiges de raccordement sont perpendiculaires au plan principal du composant. Ces constructions sont inapplicables au type de composant présentant les extrémités de ses tiges de raccordements dans un plan parallèle au plan principal du composant.

Le but de la présente invention est de résoudre ce problème pour le composant défini ci-dessus. Le socle selon l'invention est défini par la revendication 1 dans une forme d'exécution et par la revendication 11 dans une seconde forme d'exécution.

Pour mieux comprendre l'invention, des formes d'exécution du socle selon l'invention vont être décrites à titre d'exemple et en se référant aux figures dans lesquelles:

la figure 1 représente une coupe à travers un socle avec un composant monté ayant une rangée de tiges, selon une première forme d'exécution,

la figure 2 représente en vue plane le même socle que la figure 1 mais sans le composant,

la figure 3 représente en coupe un socle pour un composant avec deux rangées de tiges, selon une variante de la première forme d'exécution,

la figure 4 représente une vue plane du socle de la figure 3,

la figure 5 représente une coupe à travers une dent de peigne,

la figure 6 représente une vue verticale d'une pièce de contact,

la figure 7 représente une coupe d'une seconde forme d'exécution à travers un socle avec un composant monté ayant au moins une rangée de tiges,

la figure 8 représente en vue plane le même socle que la figure 7 mais sans le composant,

la figure 9 représente un socle pour un composant avec deux rangées de tiges dans une autre forme d'exécution, et

la figure 10 représente une vue plane du socle de la figure 9, mais sans le composant.

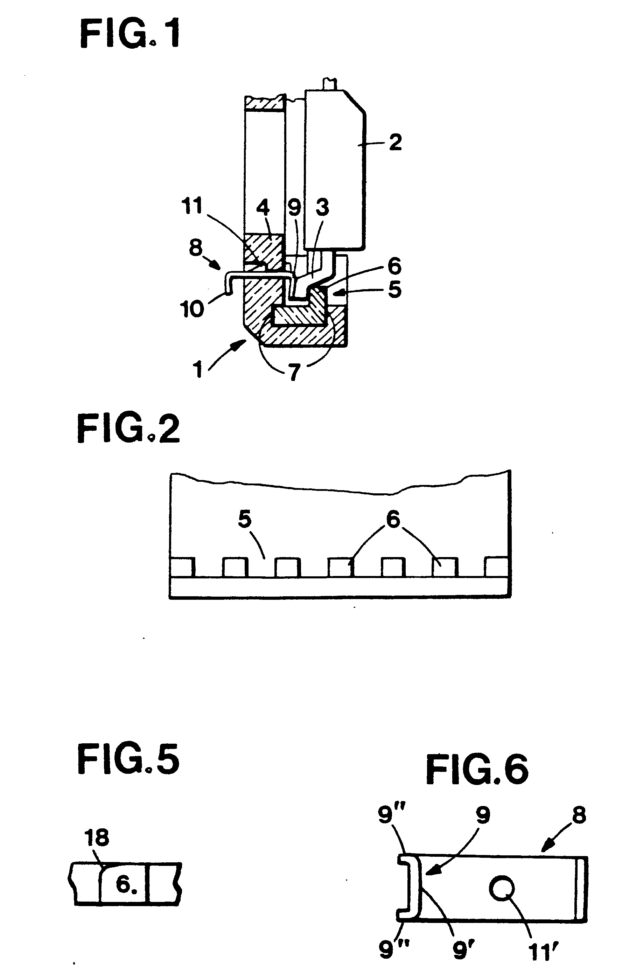

Dans une première forme d'exécution pour un composant avec une rangée de tiges, représentée à la figure 1 en coupe et à la figure 2 en plan, on reconnaît le socle 1 et le composant 2. Le composant 2 est aplati et définit par là son plan principal. Les tiges conductrices de raccordement 3 sortent latéralement du corps du composant et après un coude présentent leurs extrémités libres parallèlement au plan principal du composant. Un tel composant - nommé SMD, c'est-à-dire surface mounted device - est fait pour être appliqué sur une surface plane dans laquelle ses tiges sont raccordées aux branches d'un circuit. Dans la première forme d'exécution, un socle 1 est intercalé entre les extrémités libres des tiges 3 du composant et les branches d'un circuit (non représentées). Ce socle 1 comprend un support en matière isolante 4 et des pièces de contact 8 traversant le support et retenues en lui, par exemple par des ergots 11. Chaque pièce de contact 8 est placée face à l'emplacement prévu pour une tige du composant de façon à exercer avec une première extrémité flexible 9 une force de contact définie sur la tige 3 lorsque le composant avec ses tiges est monté dans le socle; la seconde extrémité 10 de la piece de contact est parallèle au plan principal du composant 1 et peut être soudée dans une surface plane de circuit (non représenté), comme l'aurait été l'extrémité des tiges conductrices 3 du composant 2 s'il avait été monté directement dans un circuit plan sans le socle.

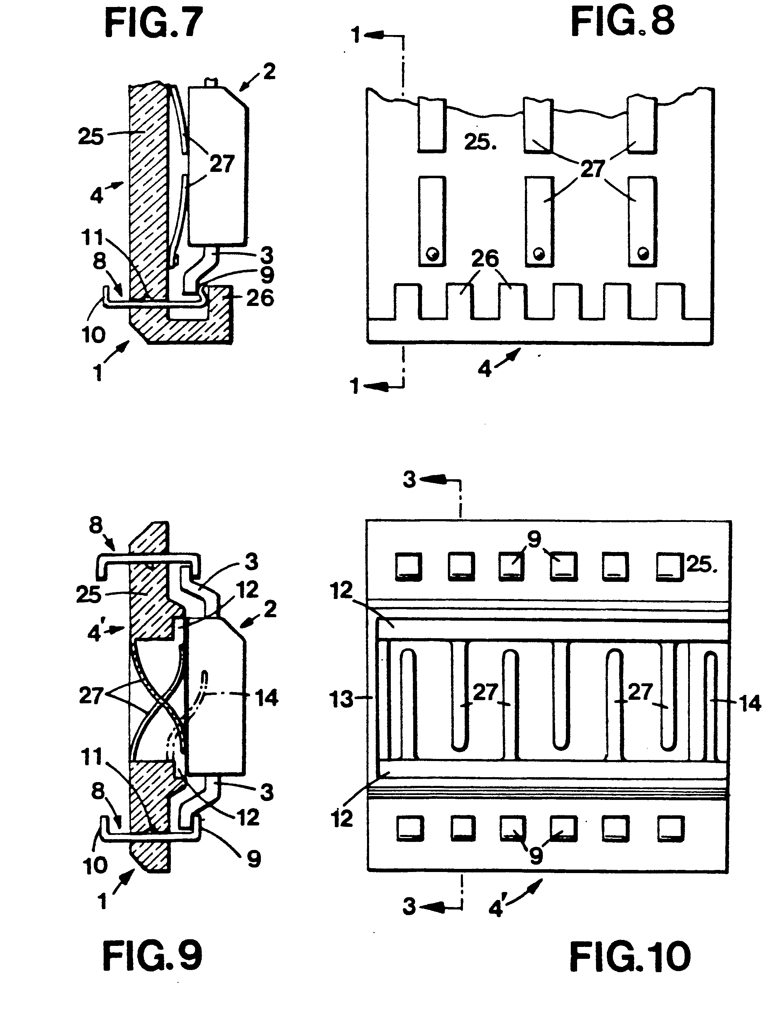

Pour que l'extrémité de la tige conductrice 3 ne cède pas à la pression de l'extrémité flexible 9 de la pièce de contact, elle est en butée sur une dent 6 d'un peigne 5 retenu en son dos dans une rainure de guidage 7 du support 4. Le peigne peut coulisser sur une distance au moins égale à la moitié du pas entre deux pièces de contact 8. La largeur des dents 6 du peigne 5 est inférieure à l'espace libre entre les deux tiges 3 du composant. Pour introduire le composant 2 dans le socle 1, les dents 6 du peigne 5 sont placées entre les pièces de contact 8. Les tiges 3 du composant sont posées sur les extrémités flexibles 9 des pièces de contact 8 et on coulisse le peigne 5 d'un demi-pas pour que chaque dent 6 forme butée contre une tige 3 correspondante subissant la force de contact de l'extrémité flexible 9 d'une pièce de contact. Pour que le déplacement coulissant du peigne 5 ne requière pas une force trop grande, l'arête 18 de la dent qui entre en contact avec la tige 3 du composant 2 est arrondie (figure 5). Ainsi la pression de contact s'établit progressivement. Cette pression est d'environ 30 grammes par contact. On voit que, sauf le frottement latéral de la dent lors de son coulissement, les tiges 3 du composant 2 ne subissent pas de force lors du montage ou du démontage du composant 2 sur le socle 1.

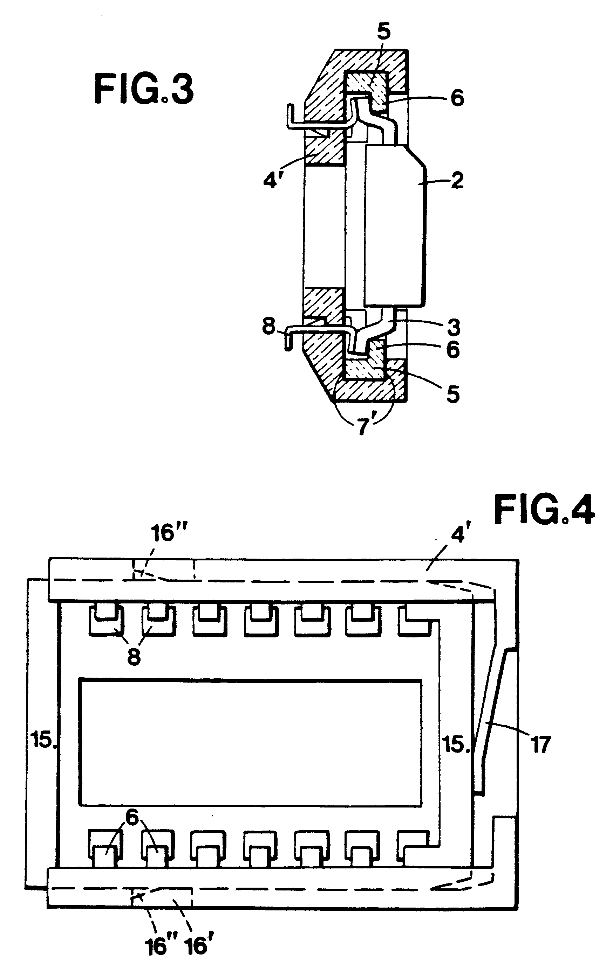

Une variante de la première forme d'exécution représentée aux figures 3 et 4 est prévue pour les composants comportant deux rangées parallèles de tiges conductrices. Deux agencements correspondant chacun à la première forme d'exécution se font face, les supports 4 étant rendus solidaires ainsi que les peignes 5, qui forment ensemble un cadre 15 coulissant dans le support 4'. Comme les rainures de guidage 7' se font face, elles peuvent avoir une forme plus simple que précédemment.

Pour que le cadre 15 ne puisse quitter de lui-même la position fermée dans laquelle les tiges 3 du composant 2 sont serrées entre les pièce de contact 8 et les dents 6, des moyens d'accrochage coopérents 16' et 16'' sont prévus respectivement sur le support et sur les dos des peignes 5 du cadre 15, sous forme d'évidement, respectivement d'ergot. Une lame flexible 17 solidaire du support 4' exerce de plus une force de retenue sur le cadre 15 pour l'empêcher de quitter la position fermée.

L'homme du métier pourra sans difficulté et sans sortir du cadre de l'invention choisir d'autres formes pour ces moyens accrochage et de retenue du cadre. Il pourra également les utiliser uniquement pour un peigne dans la première forme d'exécution décrit ci-dessus.

On peut également prévoir dans le support une empreinte en creux à l'emplacement destiné à chaque tige du composant. Cela permet dans certaines conditions de diminuer la hauteur du socle sans affecter sa solidité (solution non représentée).

On peut encore prévoir que l'extrémité flexible 9 de la pièce de contact 8 a une forme complémentaire à celle de la tige 3 avec laquelle elle est destinée à faire contact. Par exemple, cetter extrémité 9 peut avoir la forme d'un U entourant sur 3 côtés la tige correspondante; comme indiqué à la figure 6, le plat 9' appuie sur la tige 3, qui est retenue latéralement par les rebords 9'' de l'extrémité 9. Naturellement, cette extrémité peut recevoir aussi un traitement de surface appliquant un revêtement sur l'extrémité pour améliorer le contact électrique.

L'homme du métier pourra sans difficulté combiner les variantes de cette forme d'exécution. Par exemple, pour un composant présentant des tiges sur les quatre côtés, quatre socles selon la première forme d'exécution peuvent être combinés, les supports étant solidaires et les peignes restant individuels pour chaque côté du composant. Pour une rangée trop longue de tiges de raccordement, on peut prévoir un support de la même longueur que la rangée à raccorder et au moins deux peignes indépendants.

Dans une seconde forme d'exécution pour le composant avec au moins une rangée de tiges, représentée à la figure 7 en coupe et à la figure 8 en plan, on reconnaît le socle 1 et le composant 2. Le composant 2 est aplati et définit par là son plan principal.

Les tiges conductrices de raccordement 3 sortent latéralement du corps du composant et après un coude présentent leurs extrémités libres parallèlement au plan principal du composant. Un tel composant - nommé SMD, c'est-à-dire surface mounted device - est fait pour être appliqué sur une surface plane dans laquelle ses tiges sont raccordées aux branches d'un circuit. Dans la première forme d'exécution, un socle 1 est intercalé entre les extrémités libres des tiges 3 du composant et les branches d'un circuit (non représentées). Ce socle 1 comprend un support en matière isolante 4 avec une base 25 et des pièces de contact 8 traversant le support et retenues en lui, par exemple par des ergots 11. Chaque pièce de contact 8 est placée face à l'emplacement prévu pour une tige du composant de façon a exercer avec une première extrémité flexible 9 une force de contact définie sur la tige 3 lorsque le composant avec ses tiges est monté dans le socle; la seconde extrémité 10 de la pièce de contact est parallèle au plan principal du composant 1 et peut être soudée dans une surface plane de circuit (non représenté), comme l'aurait été l'extrémité des tiges conductrices 3 du composant 2 s'il avait été monté directement dans un circuit plan sans le socle. Des moyens élastiques 27 sont prévus pour pousser le composant 2 loin de la base 25 du support 4 et ainsi presser les extrémités libres des tiges 3 du composant contre les premières extrémités 9 des pièces de contact 8.

Pour que l'extrémité flexible 9 de la pièce de contact 8 ne cède pas à la pression de l'extrémité libre de la tige conductrice 3, une portion de la pièce de contact s'appuie dans la forme d'exécution de la figure 6 sur une dent 26 solidaire du support 4. L'intervalle libre entre deux dents 26 est plus large qu'une tige 3 du composant.

On introduit le composant 2 dans le socle 1, avec un décalage d'un demi-pas, chaque tige 3 passant entre deux dents 6 et les pièces de contact 8 correspondantes. Le composant 2 est pressé contre le support 4 de façon à écraser les moyens élastiques 27 et on déplace le composant longitudinalement dans le sens de l'alignement des tiges d'un demi-pas et on le relâche. Les moyens élastiques 27 pressent maintenant le composant 2 pour l'éloigner du support 4 et la réaction à cette force est donnée par la pression de contact qui s'établit entre chaque extrémité libre de tige 3 avec la première extrémité 9 de la pièce de contact correspondante. Cette pression est d'environ 30 grammes par contact. On voit que, lors du déplacement latéral du composant 2, les tiges 3 du composant 2 ne subissent pas de contrainte lors du montage ou du démontage du composant 2 sur le socle 1. Même si la pression de contact n'est pas totalement supprimée mais réduite par exemple à 10 % de sa valeur, il n'y aura plus de contrainte latérale notable sur les tiges lors du déplacement longitudinal.

Une variante de la seconde forme d'exécution, représentée aux figures 8 et 9, est prévue pour les composants comportant deux rangées parallèles de tiges conductrices. Deux agencements semblables à la première forme d'exécution se font face avec un support double 4' fait d'une pièce, qui porte deux rangées de pièces de contact 8.

Dans la forme d'exécution décrite ici, on a renoncé aux dents 26 sur lesquelles s'appuyaient les premières extrémités élastiques 9 des pièces de contact 8 dans l'exécution de la figure 6. Les pièces de contact 8 sont maintenant plus fortes et ne doivent plus s'appuyer. Les moyens élastiques 27 sont faits et montés d'une pièce avec le support 4' et en même matière que lui; ils sont agencés de façon à exercer une force répartie uniformément sur le composant on voit sur la base 25 du support 4' des rainures de guidage 12, maintenant latéralement le corps du composant 2 lorsque celui-ci est pressé contre le support 4' et déplacé longitudinalement. Aux figures 9 et 10, on voit des butées longitudinales fixe 13 et flexible 14 maintenant le composant 2 dans la position correcte, ses tiges face aux pièces de contact, lorsqu'il est relâché, tout en permettant son introduction, la butée flexible 14 étant temporairement écrasée.

On peut aussi donner aux premières extrémités 9 des pièces de contact 8 une forme complémentaire à la périphérie des extrémités libres des tiges 3, par exemple la forme d'un U entourant la tige, de sorte à garantir ainsi le maintien au moins longitudinal du composant par rapport au socle. L'homme du métier imaginera facilement des butées latérales maintenant latéralement le composant, lorsque celui-ci est relâché et sort des rainures de guidage latéral 12.

L'homme du métier pourra sans difficulté et sans sortir du cadre de l'invention choisir d'autres formes pour les moyens élastiques, les moyens de butée et de maintien. Il pourra également utiliser de tels moyens pour la première forme d'exécution.

Dans chacune des formes d'exécution, lorsque les tiges du composant 2 présentent un centre de symétrie, de sorte que le composant peut être inséré dans le socle 1 selon deux orientations, un moyen asymétrique peut être prévu sur le socle de façon que seule la bonne position d'insertion peut être utilisée; ce moyen asymétrique peut être un ergot du socle coopérant avec une asymétrie du boîtier du composant. Un tel ergot n'est pas représenté dans les dessins, ces constructions étant bien connues des hommes du métier.

On a indiqué que les pièces de contact 8 traversant le support sont retenues en lui par exemple par un ergot. Naturellement les pièces de contact peuvent aussi être prises dans la masse de moulage et ont alors de préférence dans la partie prise dans la masse de moulage un trou 11' (fig. 6) permettant à la masse de moulage de couler et en se solidifiant de retenir par là la pièce de contact.

**Revendications**

1. Socle de maintien et de raccordement (1) pour un composant électronique (2) comportant un corps et des tiges conductrices alignées (3) permettant le raccordement électrique du composant par contact avec ces tiges, l'extrémité libre des tiges étant agencée parallèlement au plan principal du composant, le socle comprenant un support en matière isolante (4) avec une base, des pièces de contact (8) retenues dans le support, le traversant et agencées chacune face à chaque emplacement prévu pour une desdites tiges de façon à exercer avec une première extrémité flexible (9) de la pièce de contact (8) une force de contact définie sur la tige (3) lorsque le composant avec ses tiges est monté dans le socle et à présenter sa seconde extrémité (10) de façon à pouvoir être soudée à une branche d'un circuit, le socle étant caractérisé en ce qu'il comprend un peigne (5) en matière isolante avec des dents (6), qui sont plus étroites que l'espace libre entre deux tiges voisines du composant et sont agencées pour correspondre aux pièces de contact (8), le dos du peigne coulissant dans une rainure de guidage (7) du support dans la direction de l'alignement des pièces de contact de façon que, avant de recevoir le composant dans le socle (6) les dents du peigne se trouvent entre les pièces de contact (8) et que, après avoir reçu le composant dans le socle et déplacé le peigne adéquatement, chaque dent se trouve en face d'une pièce de contact et presse la tige correspondante du composant monté contre cette pièce de contact.

2. Socle selon la revendication 1 pour un composant électronique comportant deux rangées parallèles de tiges conductrices, caractérisé en ce que le support (4') porte deux rangées parallèles de pièces de contact (8) correspondantes, que les extrémités du peigne (5) correspondant à une rangée sont reliées aux extrémités du peigne (5) correspondant à l'autre rangée, les peignes ainsi reliés fermant un cadre (15) coulissant dans un guidage (7') correspondant du support (4') (Fig. 3 et 4).

3. Socle selon la revendication 1 ou 2, caractérisé en ce que le peigne, respectivement le cadre, comporte un moyen d'accrochage (16") avec le support, pour empêcher le peigne, respectivement le cadre, de quitter la position fermée dans laquelle les tiges du composant sont retenues.

4. Socle selon l'une des revendications 1 à 3, caractérisé en ce que le support comporte un moyen d'accrochage (16') et/ou de retenue (17) avec le peigne, respectivement le cadre, pour l'empêcher de quitter la position fermée dans laquelle les tiges du composant sont retenues.

5. Socle selon les revendications 3 et 4, caractérisé en ce que le moyen d'accrochage (16") du peigne, respectivement du cadre, coopère avec le moyen d'accrochagé (16') du support.

6. Socle selon l'une des revendications 3 à 5, caractérisé en ce que le moyen d'accrochage et/ou le moyen de retenue est élastique et est fait d'une pièce avec la pièce qui le porte.

7. Socle selon l'une des revendications 1 à 6, caractérisé en ce que le rebord de la dent (6) qui est destinée à entrer en contact avec une tige du composant durant le coulissement du peigne de la position ouverte à la position fermée est arrondie (18) pour que la pression de contact s'établisse progressivement.

8. Socle selon l'une des revendications 1 à 7, caractérisé en ce que le support présente à l'emplacement destiné à chaque tige du composant une empreinte en creux.

9. Socle selon l'une des revendications 1 à 8, caractérisé en ce que l'extrémité flexible (9) de la pièce de contact (8) a une forme complémentaire de celle de la tige (3) avec laquelle elle est destinée à faire contact.

10. Socle selon l'une des revendications 1 à 9, caractérisé en ce qu'un moyen asymétrique adéquat est prévu pour permettre seulement l'insertion du composant dans l'orientation prévue et empêcher l'insertion dans toute autre orientation.

11. Socle de maintien et de raccordement (1) pour un composant électronique (2) comportant un corps et des tiges conductrices alignées (3) permettant le raccordement électrique du composant par contact avec ces tiges, l'extrémité libre des tiges étant agencée parallèlement au plan principal du composant, le socle comprenant un support en matière isolante (4) avec une base (25), des pièces de contact (8) retenues dans le support, le traversant et agencées chacune face à chaque emplacement prévu pour une desdites tiges de façon à exercer avec une première extrémité flexible (9) de la pièce de contact (8) une force de contact définie sur l'extrémité libre de la tige (3) lorsque le composant avec ses tiges est monté dans le socle et à présenter sa seconde extrémité (10) de façon à pouvoir être soudée à une branche d'un circuit, le socle étant caractérisé en ce qu'il comprend des moyens élastiques (27) fixés à la base (5) du support (4), capables d'exercer sur le composant (2) une force perpendiculaire au plan principal du composant de façon à presser les extrémités libres des tiges (3) du composant contre les premières extrémités (9) des pièces de contact (8) et capables de se comprimer suffisamment sous l'action d'une force appliquée sur le composant (2) en direction du support pour que les extrémités libres des tiges (3) du composant soient dégagées des premières extrémités (9) des pièces de contact (8), de façon à permettre un déplacement longitudinal du composant (2) dans la direction de l'alignement des tiges conductrices (3) sans que ces tiges ne subissent de contrainte notable et/ou ne frottent aux premières extrémités (9) des pièces de contact (8).

12. Socle selon la revendication 11, caractérisé en ce que le support (4) comporte au-dessus de chaque première extrémité (9) d'une pièce de contact (8) une dent (26) sur laquelle une portion de la pièce de contact (8) proche de la première extrémité (9) peut prendre appui, au moins lorsque le composant (2) est monté dans le socle (1).

13. Socle selon la revendication 11 ou 12, caractérisé en ce que les moyens élastiques (27) sont faits dans la même matière que le support (4) et d'une pièce avec lui.

14. Socle selon l'une des revendications 11 à 13, caractérisé en ce que les moyens élastiques (27) comportent plusieurs lames élastiques indépendantes réparties sur la longueur et/ou la largeur de la base (25) du support pour assurer une force uniformément répartie sur le corps du composant (2).

15. Socle selon l'une des revendications 11 à 14, caractérisé en ce que la base (25) porte une rainure de guidage latéral (12) pour guider latéralement le composant (2) lorsque celui-ci est déplacé longitudinalement.

16. Socle selon l'une des revendications 11 à 15 pour un composant électronique comportant deux rangées parallèles de tiges conductrices, caractérisé en ce que le support (4') porte deux rangées parallèles de pièces de contact (8) correspondantes.

17. Socle selon l'une des revendications 11 à 16, caractérisé en ce que le support (4') comporte des butées longitudinales (13, 14) et éventuellement latérales empêchant le composant (2) de se déplacer longitudinalement et éventuellement latéralement en position montée, lorsque les moyens élastiques (27) pressent les extrémités libres des tiges (3) du composant contre les premières extrémités (9) des pièces de contact (8).

18. Socle selon l'une des revendications 11 à 17, caractérisé en ce qu'un moyen asymétrique adéquat est prévu pour permettre seulement l'insertion du composant dans l'orientation prévue et empêcher l'insertion dans toute autre orientation.

19. Socle selon l'une des revendications 1 à 18, caractérisé en ce que l'extrémité flexible (9) de la pièce de contact (8) présente une forme de U (9', 9") de manière à entourer la tige (3) sur trois côtés.

**Patentansprüche**

1. Halte- und Anschluss-Sockel (1) für ein elektronisches Bauteil (2), bestehend aus einem Körper und in einer Reihe angeordneten, leitenden Stiften (3), wodurch der elektrische Anschluss des Körpers durch Kontakt mit diesen Stiften möglich wird und das freie Endstück der Stifte parallel zur Hauptebene des Bauteils angeordnet ist, während der Sockel einen Isoliermaterial-Träger (4) aufweist mit einer Basis und mit Kontaktstücken (8), welche im Träger festgehalten werden, ihn durchqueren und wobei jedes Kontaktstück der für einen dieser Stifte

vorgesehenen Stelle gegenüberliegt, so dass mit einem ersten biegsamen Ende (9) des Kontaktstückes (8) ein bestimmter Kontaktdruck auf den Stift (3) ausgeübt wird, wenn das Bauteil mit seinen Stiften auf den Sockel montiert ist, und sein zweites Ende (10) so angeordnet ist, dass es an einen Zweig einer Schaltung gelötet werden kann, wobei der Sockel dadurch gekennzeichnet ist, dass er einen Kamm (5) aus Isoliermaterial mit Zähnen (6) aufweist, welche schmaler als der freie Raum zwischen 2 nebeneinanderliegenden Stiften des Bauteiles und so ausgerichtet sind, dass sie den Kontaktstücken (8) entsprechen, und wobei der Rücken des Kammes in einer Führungsrille (7) des Trägers in Richtung der Reihe der Kontaktstücke so gleitet, dass sich die Zähne des Kamms vor dem Aufstecken des Bauteiles auf den Sockel (6) zwischen den Kontaktstücken (8) befinden, und dass sich andererseits nach dem Aufstecken des Bauteiles auf den Sockel (6) und nach entsprechendem Verschieben des Kamms jeder Zahn sich gegenüber einem Kontaktstück befindet und den entsprechenden Stift des aufmontierten Bauteils gegen dieses Kontaktstück drückt.

2. Sockel nach Patentanspruch 1 für ein elektronisches Bauteil mit zwei parallelen Reihen leitender Stifte, dadurch gekennzeichnet, dass die Stütze (4') zwei parallele Reihen zusammenpassender Kontaktstücke (8) trägt, dass die einer Reihe entsprechenden Kammenden (5) mit den dazu passenden Kammenden (5) der anderen Reihe verbunden sind und die somit verbundenen Kämme einen Rahmen (15) bilden, der in einer entsprechenden Führungsschiene (7') der Stütze (4') gleitet (Fig. 3 und 4).

3. Sockel nach Patentanspruch 1 oder 2, dadurch gekennzeichnet, dass der Kamm beziehungsweise der Rahmen eine Vorrichtung zum Einhaken (16'') mit der Stütze besitzt, um sicherzustellen, dass der Kamm beziehungsweise der Rahmen in der geschlossenen Lage bleibt, in der die Bauteilstifte festgehalten sind.

4. Sockel nach einem der Patentansprüche 1 bis 3, dadurch gekennzeichnet, dass die Stütze eine Vorrichtung zum Einhaken (16') und/oder Halten (17) mit dem Kamm bzw. dem Rahmen aufweist, um sicherzustellen, dass sie in der geschlossenen Position bleibt, in der die Bauteilstifte festgehalten werden.

5. Sockel nach den Patentansprüchen 3 und 4, dadurch gekennzeichnet, dass die Einhakvorrichtung (16'') des Kammes beziehungsweise des Rahmens mit jener (16') der Stütze zusammenwirkt.

6. Sockel nach einem der Patentansprüche 3 bis 5, dadurch gekennzeichnet, dass die Einhak- und/oder Haltevorrichtung elastisch ist/sind und mit ihrem Träger zusammen aus einem Stück gemacht ist/sind.

7. Sockel nach einem der Patentansprüche 1 bis 6, dadurch gekennzeichnet, dass der Rand des Zahnes (6), welcher mit dem Bauteilstift Kontakt machen soll während der Kamm durch Gleiten geschlossen wird, abgerundet ist (18), damit der Kontaktdruck sich allmählich aufbaut.

8. Sockel nach einem der Patentansprüche 1 bis 7, dadurch gekennzeichnet, dass die Stütze an allen für die Bauteilstifte vorgesehenen Stellen Einbuchtungen aufweist.

9. Sockel nach einem der Patentansprüche 1 bis 8, dadurch gekennzeichnet, dass das biegsame Ende (9) des Kontaktstückes (8) eine Form hat, die zur Form des Stiftes (3) passt, mit dem der Kontakt hergestellt werden soll.

10. Sockel nach einem der Patentansprüche 1 bis 9, dadurch gekennzeichnet, dass ein passendes asymmetrisches Element zur Einführung des Bauteiles nur in der vorgesehenen Richtung gedacht ist, wodurch jede andere Einführung verhindert wird.

11. Halte- und Anschluss-Sockel (1) für ein elektronisches Bauteil (2), bestehend aus einem Körper und in einer Reihe angeordneten, leitenden Stiften (3), wodurch der elektrische Anschluss des Körpers durch Kontakt mit diesen Stiften möglich wird und das freie Endstück der Stifte parallel zur Hauptebene des Bauteils angeordnet ist, während der Sockel einen Isoliermaterial-Träger (4) mit einer Basis (25), in der Stütze festsitzende und durchgehende Kontaktstücke (8) aufweist, wovon jeder gegenüber einem für einen Stift vorgesehenen Platz angeordnet ist, so dass mit einem ersten biegsamen Ende (9) des Kontaktstückes (8) ein bestimmter Druck auf das freie Ende des Stiftes (3) ausgeübt wird, sobald das Bauteil mit seinen Stiften in den Sockel eingesteckt wird und das zweite Ende (10) so liegt, dass es an eine Stromabzweigung geschweisst werden kann und der Sockel dadurch gekennzeichnet ist, dass er elastische Elemente aufweist (27), die - auf der Basis (5) der Stütze (4) befestigt - in der Lage sind, auf das Bauteil (2) einen zur Hauptebene des Bauteils senkrechten Druck auszuüben, so dass die freien Enden der Stifte (3) des Bauteils auf die ersten Enden (9) des Kontaktstückes (8) drücken und sich genügend zusammenpressen können, sobald eine Krafteinwirkung auf das Bauteil (2) in Richtung Stütze erfolgt, damit die freien Enden der Stifte (3) des Bauteiles von den ersten Enden (9) der Kontaktstücke (8) frei sind und damit ein Verschieben des Bauteils (2) in Längsrichtung möglich ist, und zwar in der selben Richtung wie die Reihen der leitenden Stifte (3), ohne diese einer merkbaren Beanspruchung auszusetzen und/oder dass sie auf die ersten Enden (9) der Kontaktstücke (8) reiben.

12. Sockel nach Patentanspruch 11, dadurch gekennzeichnet, dass die Stütze (4) über jedem ersten Ende (9) eines Kontaktstückes (8) einen Zahn (26) aufweist, auf dem sich ein Teil des Kontaktstückes (8) nahe dem ersten Ende (9) abstützen kann, und zwar zumindest während der Montage des Bauteiles (2) am Sockel (1).

13. Sockel nach Patentanspruch 11 oder 12, dadurch gekennzeichnet, dass die elastischen Elemente (27) aus dem gleichen Material wie die Stütze (4) und einstückig damit gefertigt sind.

14. Sockel nach einem der Patentansprüche 11 bis 13, dadurch gekennzeichnet, dass die elastischen Elemente (27) mehrere unabhängige elastische Streifen beinhalten, die über die Länge und/oder die Breite der Basis (25) für die Stütze verteilt sind, damit die Kraft gleichmässig über den Bauteilkörper (2) verteilt wird.

15. Sockel nach einem der Patentansprüche 11 bis 14, dadurch gekennzeichnet, dass die Basis (25) eine seitliche Führungsrille (12) aufweist, damit das Bauteil (2) seitlich geführt werden kann, wenn es in Längsrichtung verschoben wird.

16. Sockel nach einem der Patentansprüche 11 bis 15 für ein elektronisches Bauteil mit zwei parallelen Reihen Führungsstifte, dadurch gekennzeichnet, dass die Stütze (4') zwei parallele Reihen entsprechender Kontaktstücke (8) aufweist.

17. Sockel nach einem der Patentansprüche 11 bis 16, dadurch gekennzeichnet, dass die Stütze (4) Längsanschläge (13, 14) und eventuell seitliche Anschläge aufweist, die das Bauteil (2) daran hindern, dass es sich in montierter Lage längs oder seitlich verschiebt, sobald die elastischen Elemente (27) die freien Enden der Bauteilstifte (3) gegen die ersten Enden (3) der Kontaktstücke (8) drücken.

18. Sockel nach einem der Patentansprüche 11 bis 17, dadurch gekennzeichnet, dass ein passendes asymmetrisches Element vorgesehen ist, damit die Einführung des Bauteiles in nur einer Lage ermöglicht und in jeder anderen Lage verhindert wird.

19. Sockel nach einem der Patentansprüche 1 bis 18, dadurch gekennzeichnet, dass das biegsame Ende (9) des Kontaktstückes (8) U-förmig (9', 9'') ausgebildet ist, so dass der Stift (3) dadurch auf drei Seiten vom biegsamen Ende eingefasst wird.

**Claims**

1. A holding and connecting socket (1) for an electronic component (2) having a body and aligned conducting pins (3) enabling the component to be electrically connected by contact with these pins, the free end of the pins being arranged parallel to the principal plane of the component, the socket comprising a support (4) made of an insulating material, with a base, and contact makers (8) held in the support, which pass through the latter and are each arranged opposite each site intended for one of the said pins so as to exert, with a first flexible end (9) of the contact maker (8), a defined contact force on the pin (3) when the component, with its pins, is mounted in the socket, and so as to present its second end (10) for soldering to an arm of a circuit, the socket being characterized in that it comprises a comb (5) made of an insulating material, with teeth (6) which are narrower than the free space between two adjacent pins of the component and are arranged so as to correspond to the contact makers (8), the back of the comb sliding in a guide groove (7) in the support, in the direction of alignment of the contact makers, so that, before receiving the component in the socket (6), the teeth of the comb are located between the contact makers (8) and so that, after having received the component in the socket and appropriately displaced the comb, each tooth is located opposite a contact maker and presses the corresponding pin of the mounted component against this contact maker.

2. The socket according to Claim 1 for an electronic component having two parallel rows of conducting pins, characterized in that the support (4') carries two parallel rows of corresponding contact makers (8), and in that the ends of the comb (5) corresponding to one row are joined to the ends of the comb (5) corresponding to the other row, the combs joined in this way forming a frame (15) sliding in a corresponding guide (7') in the support (4') (Figures 3 and 4).

3. The socket according to Claim 1 or Claim 2, characterized in that. the comb or frame, respectively, has a means (16'') of attachment to the support in order to prevent the comb or frame from leaving the closed position in which the pins of the component are held.

4. The socket according to any one of Claims 1 to 3, characterized in that the support has a means (16') of attachment to, and/or means (17) for retaining, the comb or frame, respectively, in order to prevent it from leaving the closed position in which the pins of the component are held.

5. The socket according to Claim 3 and Claim 4, characterized in that the means of attachment (16'') on the comb or frame, respectively, cooperates with the means of attachment (16') on the support.

6. The socket according to any one of Claims 3 to 5, characterized in that the means of attachment and/or the means of retention is elastic and is made in one piece with the part by which it is carried.

7. The socket according to any one of Claims 1 to 6, characterized in that the rim of the tooth (6) which is intended to come into contact with a pin of the component as the comb slides from the open position to the closed position is rounded (18) so that the contact pressure is created gradually.

8. The socket according to any one of Claims 1 to 7, characterized in that the support has a recess at the site intended for each pin of the component.

9. The socket according to any one of Claims 1 to 8, characterized in that the flexible and (9) of the contact maker (8) has a shape which complements that of the pin (3) with which it is intended to make contact.

10. The socket according to any one of Claims 1 to 9, characterized in that an appropriate asymmetrical means is provided so as to allow the component to be inserted only in the intended orientation and to prevent it from being inserted in any other orientation.

11. A holding and connecting socket (1) for an electronic component (2) having a body and aligned conducting pins (3) enabling the component to be electrically connected by contact with these pins, the free end of the pins being arranged parallel to the principal plane of the component, the socket comprising a support (4) made of an insulating materials with a base (25), and contact makers (8) held in the supports which pass through the latter and are each arranged opposite each site intended for one of the said pins so as to exert, with a first flexible end (9) of the contact maker (8), a defined contact force on the free end of the pin (3) when the component, with its pins, is mounted in the socket, and so as to present its second end (10) for soldering to an arm of a circuit, the socket being characterized in that it comprises elastic means (27) fixed to the base (5) of the support (4), which are capable of exerting, on the component (2), a force perpendicular to the principal plane of the component so as to press the free ends of the pins (3) of the component against the first ends (9) of the contact makers (8), and which are capable of compressing sufficiently, under the action of a force applied to the component (2) in the direction of the support, for the free ends of the pins (3) of the component to be disengaged from the first ends (9) of the contact makers (8), thereby allowing a longitudinal displacement of the component (2), in the direction of alignment of the conducting pins (3), without these pins being subjected to appreciable stress and/or rubbing against the first ends (9) of the contact makers (8).

12. The socket according to Claim 11, characterized in that, above each first end (9) of a contact maker (8), the support (4) has a tooth (26) on which a portion of the contact maker (8) close to the first end (9) can rest, at least when the component (2) is mounted in the socket (1).

13. The socket according to Claim 11 or Claim 12, characterized in that the elastic means (27) are made of the same material as the support (4) and in one piece therewith.

14. The socket according to any one of Claims 11 to 13, characterized in that the elastic means (27) have several independent elastic strips distributed over the length and/or width of the base (25) of the support in order to ensure that the force is uniformly distributed over the body of the component (2).

15. The socket according to any one of Claims 11 to 14, characterized in that the base (25) has a lateral guide groove (12) for guiding the component (2) laterally when the latter is displaced longitudinally.

16. The socket according to any one of Claims 11 to 15 for an electronic component having two parallel rows of conducting pins, characterized in that the support (4') carries two parallel rows of corresponding contact makers (8).

17. The socket according to any one of Claims 11 to 16, characterized in that the support (4') has longitudinal stops (13, 14) and, if appropriate, lateral stops preventing the component (2) from moving longitudinally and, if appropriate, laterally in the mounted position when the elastic means (27) press the free ends of the pins (3) of the component against the first ends (9) of the contact makers (8).

18. The socket according to any one of Claims 11 to 17, characterized in that an appropriate asymmetrical means is provided so as to allow the component to be inserted only in the intended orientation and to prevent it from being inserted in any other orientation.

19. The socket according to any one of Claims 1 to 18, characterized in that the flexible end (9) of the contact maker (8) is U-shaped (9', 9'') so as to surround the pin (3) on three sides.

# FIG. 1

# FIG. 2

# FIG. 5

# FIG. 6

1

FIG.3

FIG.4

# FIG.7

# FIG.8

# FIG.9

# FIG.10